# EUROPEAN PATENT APPLICATION

(11) **EP 2 009 661 A2**
(43) Date of publication of application: **31.12.2008**
(21) Application number: 08010483.9
(22) Date of filing: 09.06.2008
(51) Int. Cl.: H01H 19/62, H03K 17/96

(54) **Rotary device**

(30) Priority: 29.06.2007 JP 2007171406
(71) Applicant: ALPS ELECTRIC CO., LTD., Tokyo 145-8501 (JP)
(72) Inventor: Onodera, Mikio, Tokyo 145-8501 (JP)
(74) Representative: Klunker . Schmitt-Nilson . Hirsch

(57) **Abstract**

Disclosed is a rotary device that rotatably and movably supports a rotary body, thereby reducing the number of parts, as compared to the related art.

A rotary body (and a code member that is supported such that it can be rotated together with the rotary body) is supported so as to be movable in an X1-X2 direction independently from a fixed base and a fixed board. A photo interrupter is fixed to the surface of the fixed base. The interrupter is arranged such that the direction of a straight line linking the center of a light emitting portion in the width direction and the center of a light receiving portion in the width direction is orthogonal to the direction in which the rotary body is moved, and when the rotary body is positioned at the center of the movement direction, the straight line passes through a rotation center.

## Description

This application claims priority to the Japanese Patent Application No. 2007-171406, filed June 29, 2007, the entirety of which is hereby incorporated by reference.

### BACKGROUND

### 1. Technical Field

The present invention relates to a rotary device that rotatably and movably supports a rotary body.

### 2. Related Art

Rotary devices include: a code member that is integrally rotated with a rotary body to detect the rotation of the rotary body and includes a code unit having light shielding portions and light transmitting portions alternately arranged in a rotation direction; and a photo interrupter that includes a light emitting portion and a light receiving portion that are opposite to each other with a gap therebetween such that, when the code member is rotated, the light shielding portion is positioned between the light emitting portion and the light receiving portion.

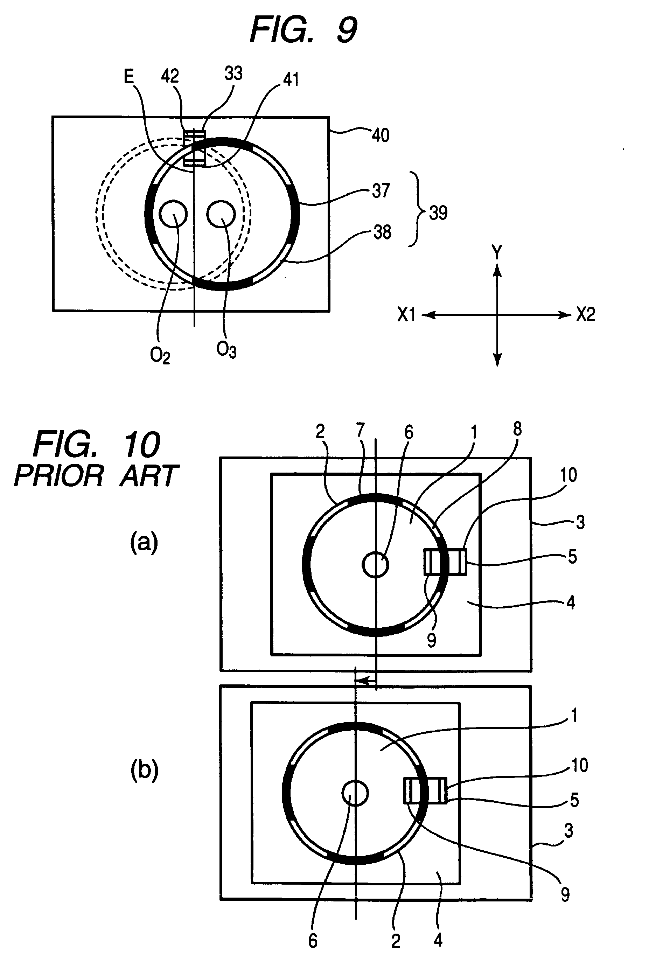

Figs. 10A and 10B are plan views illustrating a rotary device according to the related art. In Figs. 10A and 10B, a rotary body is not shown. In Figs. 10A and 10B, a light shielding portion and a light transmitting portion of the code unit are shown in a perspective view.

As shown in Fig. 10A, a movable board 4 is provided on a fixed base 3, and a photo interrupter 5 is provided on the movable board 4. The photo interrupter 5 is fixed to the movable board 4.

A groove is formed in the surface of the fixed base 3, and a shaft 6 is inserted into the groove. The shaft 6 extends upward through the movable board 4, and a code member 1 and a rotary body (not shown) are supported by the shaft 6 such that they can rotate on the center of the shaft 6, which is a rotation center.

As shown in Fig. 10A, a code unit 2 is provided in an outer circumferential portion of the code member 1. The code unit 2 includes light shielding portions 7 and light transmitting portions 8 alternately arranged along the circumference. In Figs. 10A and 10B, dark portions indicate the light shielding portions 7. The light shielding portions 7 protrude from the surface of the movable board 4. As shown in Fig. 10A, the light shielding portion 7 is positioned between a light emitting portion 9 and a light receiving portion 10 of the photo interrupter 5. In the positional relationship shown in Fig. 10A, the light shielding portion 7 blocks an optical path between the light emitting portion 9 and the light receiving portion 10 of the photo interrupter 5. Meanwhile, the light transmitting portion 8 does not protrude unlike the light shielding portion 7, but is formed by cutting a portion of a cylindrical light shielding wall. In the related art, the light transmitting portion 8 is formed so as to be flush with the rear surface of the code member 1. Therefore, even though the light transmitting portion 8 is positioned between the light emitting portion 9 and the light receiving portion 10 in plan view, the light transmitting portion 8 does not block the optical path of the photo interrupter 5. Therefore, it is possible to detect the rotation of the rotary body on the basis of signals that are output from the photo interrupter 5 when the optical path is blocked or not blocked by the rotation of the code member 1.

In the rotary device shown in Figs. 10A and 10B, the rotary body can be moved from the state shown in Fig. 10A to the left side, as shown in Fig. 10B. In this case, the code member 1 is integrally moved with the rotary body, and the movable board 4 having the photo interrupter 5 formed thereon can also slide to the left side together with the rotary body.

A flexible wiring board (not shown) having a sufficient length not to hinder the movement of the photo interrupter 5 is connected to the photo interrupter 5, which makes it possible to move the photo interrupter 5 together with the movable board 4.

However, in the rotary device according to the related art shown in Figs. 10A and 10B, a long flexible wiring board is needed to move the photo interrupter 5, or the movable board 4 moved together with the photo interrupter 5 and a mechanism for moving the movable board 4 are needed, which results in an increase in the number of parts.

In addition, it is necessary to ensure a space for accommodating the long flexible wiring board, and the number of parts increases. As a result, it is difficult to reduce the size of the rotary device.

Japanese Unexamined Patent Application Publication No. 2004-87307 does not refer to the problems of the above-mentioned structure according to the related art, and thus does not disclose means for solving the problems.

### SUMMARY

An advantage of some aspects of the invention is to provide a rotary device that rotatably and movably supports a rotary body, thereby reducing the number of parts, as compared to the related art.

According to an aspect of the invention, a rotary device includes: a rotary body rotatably supported above a fixed base; a code member provided below the rotary body so as to be rotatably supported together with the rotary body and including a code unit having light shielding portions and light transmitting portions alternately arranged in a rotation direction; and a photo interrupter including a light emitting portion and a light receiving portion that are opposite to each other with a gap therebetween such that, when the code member is rotated, the light shielding portion is positioned in a light detection space between the light emitting portion and the light receiving portion. The rotary body is supported in a direction substantially orthogonal to a rotation axis such that it can move independently from the fixed base, and the photo interrupter is fixed to the fixed base. The arrangement of the photo interrupter with respect to the code unit is configured such that, in the entire movement range of the rotary body, the photo interrupter does not contact the light shielding portion of the code unit all the time and the code unit is positioned between the light receiving portion and the light emitting portion all the time.

According to the rotary device having the above-mentioned structure, unlike the related art, a sufficiently long flexible wiring board to allow the movement of the photo interrupter, a movable board that is moved together with the rotary body, and a support mechanism therefor are not needed. Therefore, it is possible to reduce the number of parts. In addition, it is possible to reduce the size of the rotary device.

In the rotary device according to the above-mentioned aspect, preferably, the photo interrupter is arranged such that the direction of a straight line linking the center of the light emitting portion in the width direction and the center of the light receiving portion in the width direction is different from the direction in which the rotary body is moved. When the direction of the straight line linking the center of the light emitting portion in the width direction and the center of the light receiving portion in the width direction is aligned with the direction in which the rotary body is moved, it is difficult to move the rotary body beyond the gap between the light emitting portion and the light receiving portion. Meanwhile, in this structure, when the direction of the straight line linking the center of the light emitting portion in the width direction and the center of the light receiving portion in the width direction is different from the direction in which the rotary body is moved, it is possible to extend the movement range of the rotary body or flexibly set the movement range by changing, for example, the shape or dimensions of the code unit.

In the rotary device according to the above-mentioned aspect, preferably, the photo interrupter is arranged such that the direction of a straight line linking the center of the light emitting portion in the width direction and the center of the light receiving portion in the width direction is orthogonal to the direction in which the rotary body is moved, and when the rotary body is positioned at the middle of the movement range, the straight line passes through a rotation center. According to this structure, it is possible to effectively extend the movement range of the rotary body that maintains a non-contact state between the photo interrupter and the light shielding portion of the code unit. In addition, it is possible to move the rotary body that is positioned at the center of the movement direction by the same distance in the horizontal direction.

In the rotary device according to the above-mentioned aspect, preferably, when the rotary body is positioned at the center of the movement direction, the photo interrupter is arranged such that the center between the light emitting portion and the light receiving portion is closer to the rotation center than the center of the width of the code unit. According to this structure, it is possible to effectively extend the movement range of the rotary body that maintains a non-contact state between the photo interrupter and the light shielding portion of the code unit.

In the rotary device according to the above-mentioned aspect, preferably, the rotary body is supported such that it can be moved between a first position and a second position for rotation, and the photo interrupter is arranged at the intersection between the first position of the code unit and the second position of the code unit.

According to this structure, it is possible to rotate the rotary body while appropriately maintaining a non-contact state between the photo interrupter and the light shielding portion of the code unit at both the first position and the second position. In addition, it is possible to effectively extend the movement range of the rotary body that maintains the non-contact state between the photo interrupter and the light shielding portion of the code unit.

In the rotary device according to the above-mentioned aspect, preferably, a pair of the photo interrupters are provided, and the pair of photo interrupters are substantially opposite to each other with a rotation center interposed therebetween when the rotary body is positioned at the center of the movement direction.

According to this structure, it is possible to appropriately detect the rotation angle and the rotation direction of the rotary body using the photo interrupter, and it is also possible to effectively extend the movement range of the rotary body that maintains the non-contact state between the photo interrupter and the light shielding portion of the code unit.

According to the rotary device having the above-mentioned structure, unlike the related art, a sufficiently long flexible wiring board to allow the movement of the photo interrupter, a movable board that is moved together with the rotary body, and a support mechanism therefor are not needed. Therefore, it is possible to reduce the number of parts. In addition, it is possible to reduce the size of the rotary device.

### BRIEF DESCRIPTION OF THE DRAWINGS

Fig. 1 is a front view illustrating an air conditioner controller using a rotary device according to an embodiment, which is provided on a control panel positioned in a front portion inside a vehicle.
Fig. 2 is a plan view illustrating the rotary device according to this embodiment.
Fig. 3 is a front view illustrating the rotary device shown in Fig. 2.
Fig. 4 is a cross-sectional view illustrating the rotary device according to this embodiment taken along the line IV-IV of Fig. 2 in a height direction (Z direction), as viewed from the direction of an arrow.
Fig. 5 is a cross-sectional view illustrating the rotary device according to this embodiment taken along the line V-V of Fig. 2 in the height direction (Z direction), as viewed from the direction of an arrow.
Fig. 6A is a plan view illustrating the rotary device at a center position, with a rotary body (rotary knob) detached from the rotary device shown in Fig. 2.
Fig. 6B is a plan view illustrating the rotary device at a left position, with the rotary body detached therefrom, when the rotary body is moved in a straight line in the left direction (X1 direction) from the state shown in Fig. 6A.
Fig. 7 is a plan view illustrating a rotary device according to another embodiment, with a rotary body detached therefrom.
Fig. 8 is a plan view illustrating a rotary device according to still another embodiment, with a rotary body detached therefrom.
Fig. 9 is a plan view illustrating a rotary device according to yet another embodiment, with a rotary body detached therefrom.
Fig. 10A is a plan view illustrating a rotary device at a center position according to the related art, with a rotary body (rotary knob) detached therefrom.
Fig. 10B is a plan view illustrating the rotary device at a left position, with the rotary body detached therefrom, when the rotary body is moved in a straight line in the left direction (X1 direction) from the state shown in Fig. 10A.

### DESCRIPTION OF EXEMPLARY EMBODIMENTS

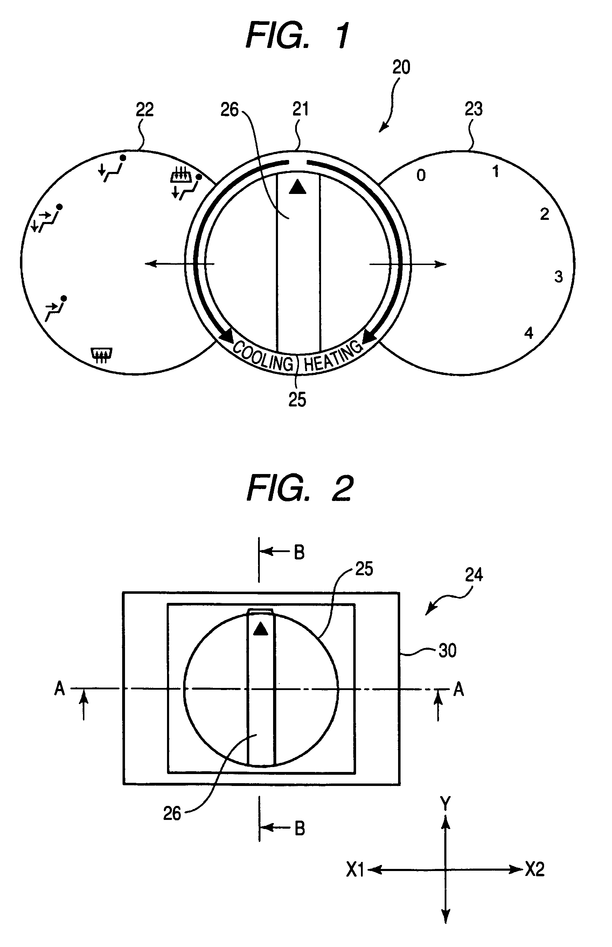

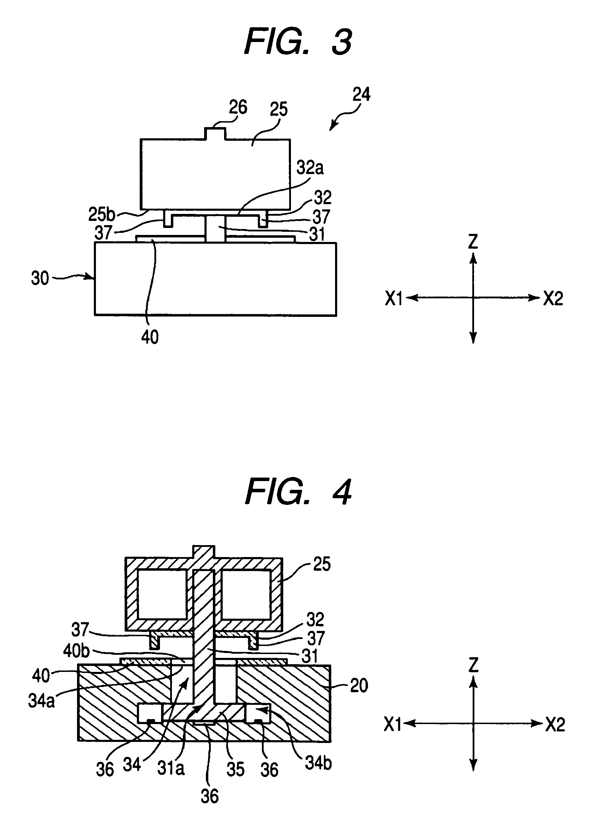

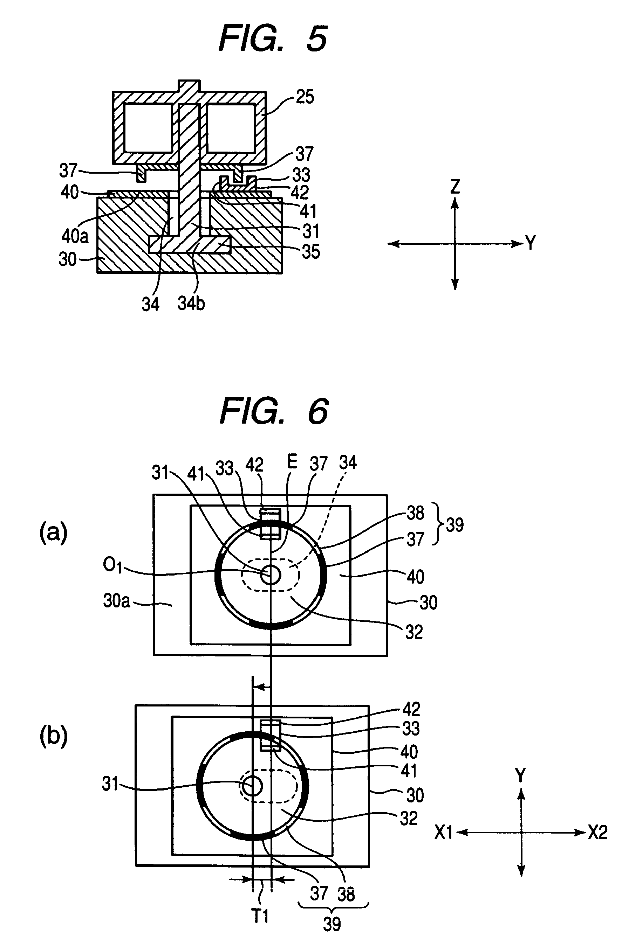

Fig. 1 is a front view illustrating an air conditioner controller using a rotary device according to an embodiment, which is provided on a control panel positioned in a front portion inside a vehicle. Fig. 2 is a plan view illustrating the rotary device according to this embodiment. Fig. 3 is a front view illustrating the rotary device shown in Fig. 2. Fig. 4 is a cross-sectional view illustrating the rotary device according to this embodiment taken along the line IV-IV of Fig. 2 in the height direction (Z direction), as viewed from the direction of an arrow. Fig. 5 is a cross-sectional view illustrating the rotary device according to this embodiment taken along the line V-V of Fig. 2 in the height direction (Z direction), as viewed from the direction of an arrow. Fig. 6A is a plan view illustrating the rotary device with a rotary body (rotary knob) detached from the rotary device shown in Fig. 2, and Fig. 6B is a plan view illustrating the rotary device with the rotary body detached therefrom, when the rotary body is moved in a straight line in the left direction (X1 direction) from the state shown in Fig. 6A.

As shown in Fig. 1, an air conditioner controller 20 is provided on a control panel of a vehicle. The air conditioner controller 20 is provided with an air conditioner switching unit 21, an air vent switching unit 22, and an airflow control unit 23.

As shown in Fig. 1, a rotary body (rotary knob) 25 forming the rotary device 24 according to this embodiment is positioned at the center of the air conditioner controller 20, and a convex knob portion 26 is provided on the surface of the rotary body 25. When the rotary body 25 is in the air conditioner switching unit 21, it is possible to perform switching between cooling and heating modes by rotating the knob portion 26.

In this embodiment, the rotary body 25 is displaceable from the center position shown in Fig. 1 to a left position, and it is possible to control the air vent at the left position by rotating the knob portion 26 of the rotary body 25. Further, in this embodiment, the rotary body 25 is displaceable from the center position shown in Fig. 1 to a right position, and it is possible to adjust the airflow at the right position by rotating the knob portion 26 of the rotary body 25.

As described above, it is possible to use one rotary device 24 to perform various functions of the air conditioner at a plurality of positions. Therefore, it is possible to reduce the number of parts of the air conditioner controller 20 and reduce the size of the air conditioner controller 20.

The structure shown in Fig. 1 is just illustrative, but the rotatable and movable rotary device 24 according to this embodiment can be applied to control devices other than the air conditioner controller in the vehicle, or it can be used for various purposes other than the vehicle.

The structure of the rotary device 24 according to this embodiment will be described with reference to Figs. 2 to 6. The rotary device 24 according to this embodiment includes a fixed base 30, the rotary body 25, a shaft 31, a code member 32, and a photo interrupter 33.

As shown in Fig. 4, a surface 30a of the fixed base 30 is opened to form a groove 34. As shown in Fig. 6A, an opening 34a of the groove 34 is elongated in an X1-X2 direction rather than in a Y direction in Fig. 4. As shown in Fig. 4, the length of an internal portion 34b, which is an internal space, of the groove 34 is larger than that of the opening 34a in the X1-X2 direction.

As shown in Figs. 4 and 5, a pedestal portion 35 having a larger size than the shaft 31 in plan view is formed in a base portion 31a of the shaft 31. The pedestal portion 35 is integrally formed with the shaft 31. The pedestal portion 35 is formed in, for example, a rectangular shape in plan view. As shown in Figs. 4 and 5, the shaft 31 and the pedestal portion 35 are inserted into the groove 34 formed in the fixed base 30.

As shown in Fig. 5, the length of the pedestal portion 35 in the Y direction is substantially equal to that of the internal portion 34b of the groove 34. However, as shown in Fig. 4, the width of the pedestal portion 35 in the X1-X2 direction is smaller than that of the internal portion 34b of the groove 34 in the X1-X2 direction, and the pedestal portion 35 can slide on the internal portion 34b of the groove 34 in the X1-X2 direction. A sensor 36 provided on the bottom of the internal portion 34b of the groove 34 can detect whether the pedestal portion 35 is at the center position, the left position shifted from the center position in the X1 direction, or the right position shifted from the center position in the X2 direction. The sensor 36 may be a contact type or a non-contact type.

As shown in Figs. 3 to 6B, a leading end of the shaft 31 having a circular shape in a cross-sectional view extends upward from the surface 30a of the fixed base 30, and the rotary body 25 is mounted to the end of the shaft 31 so as to be rotatable on the center of the shaft 31 as a rotation center.

The code member 32 is mounted to a rear surface 25b of the rotary body 25 with an adhesive layer interposed therebetween. The code member 32 has, for example, a circular shape in a plan view, similar to the rotary body 25. A hole through which the shaft 31 passes is formed in the center of the code member 32, and the code member 32 and the rotary body 25 are rotatably supported by the shaft.

In this embodiment, the rotary body 25 is formed separately from the code member 32, but the invention is not limited thereto. The rotary body 25 may be integrally formed with the code member 32.

As shown in Figs. 3 to 6B, a code unit 39 having light shielding portions 37 and light transmitting portions 38 that are alternately formed is provided in an outer circumferential portion of the code member 32.

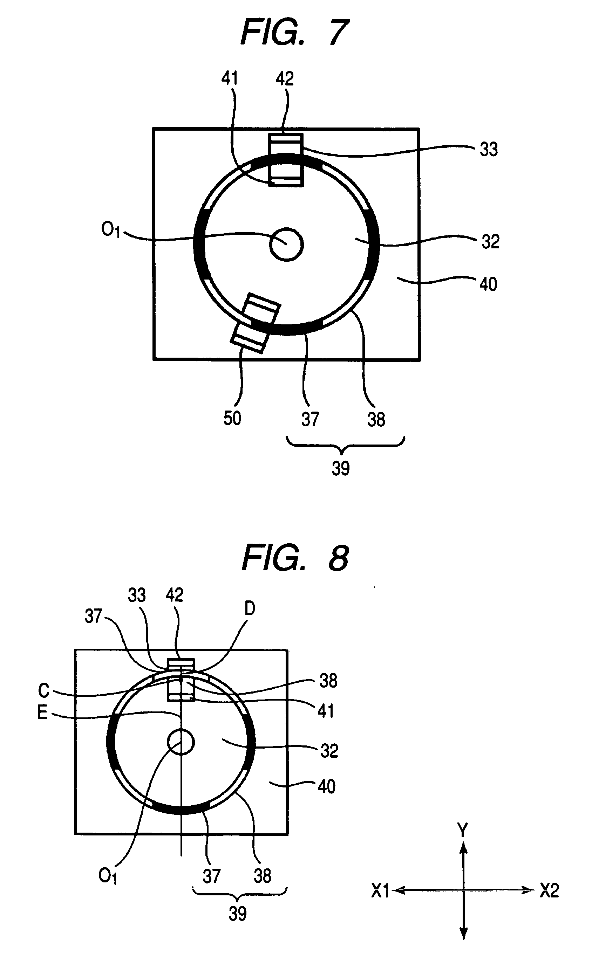

Figs. 6A and 6B and Figs. 7 to 9, which will be described below, are plan views illustrating the code unit 39 of the code member 32, in which black portions indicate the light shielding portions 37. However, in Fig. 8, in order for easy recognition of the center C between a light emitting portion 41 and a light receiving portion 42 of the photo interrupter 33 and the center D of the width of the light shielding portion 37, all the light shielding portions 37 between the light emitting portion 41 and the light receiving portion 42 are not painted black.

As shown in Figs. 3 to 5, the light shielding portion 37 protrudes from the rear surface 32a of the code member 32 to the fixed base 30. Meanwhile, the light transmitting portions 38 are formed so as to be flush with the rear surface 32a of the code member 32.

As shown in Figs. 3 to 6B, a fixed board 40 having a smaller plane area than the fixed base 30 is fixed to the fixed base 30 with an adhesive layer interposed therebetween.

A through hole 40b having substantially the same size as the opening 34a of the fixed base 30 is formed at the center of the fixed board 40, such that the fixed base does not hinder the movement of the shaft 31 in the X1-X2 direction.

As shown in Figs. 5, 6A and 6B, the photo interrupter 33 is fixed to the surface 40a of the fixed board 40.

The photo interrupter 33 has two protrusions that protrude upward. One of the two protrusions serves as the light emitting portion 41, and the other protrusion serves as the light receiving portion 42. The light emitting portion 41 and the light receiving portion 42 are opposite to each other with a gap therebetween. The position of the photo interrupter 33 on the fixed board 40 is restricted such that the light shielding portion 37 is positioned in a light detection space between the light emitting portion 41 and the light receiving portion 42 when the code member 32 is rotated.

When the light shielding portion 37 is positioned in the light detection space between the light emitting portion 41 and the light receiving portion 42 of the photo interrupter 33, the light shielding portion 37 blocks an optical path. However, the light transmitting portion 38 does not block the optical path even when it is positioned between the light emitting portion 41 and the light receiving portion 42, in plan view. In this way, when the code unit 39 is rotated, the state of the optical path is changed between a blocked state and a non-blocked state, and then signals are output from the photo interrupter 33. Therefore, it is possible to detect the rotation of the rotary device on the basis of the signals output from the photo interrupter 33.

The fixed board 40 is optional. The fixed board 40 may not be provided. In this case, the photo interrupter 33 is directly fixed to the fixed base 30.

As shown in Figs. 6A and 6B, the rotary body 25 is supported such that it can move in the X1-X2 direction. Meanwhile, as shown in Figs. 5, 6A, and 6B, the Y direction indicates the direction of a straight line E linking the center of the light emitting portion 41 in the width direction and the center of the light receiving portion 42 in the width direction in the photo interrupter 33. In addition, as shown in Fig. 6A, when the rotary body 25 is disposed at the center (center position) in the movement direction (X1-X2 direction), the photo interrupter 33 is arranged such that the straight line E passes through the rotation center O1.

Figs. 6A and 6B do not show the rotary body 25. However, since the code member 32 shown in Figs. 6A and 6B moves together with the rotary body 25, the movement of the code member 32 shown in Figs. 6A and 6B means the movement of the rotary body 25. This is similarly applied to Figs. 7 to 9.

Next, characteristics of the rotary device 24 according to this embodiment will be described. In this embodiment, as shown in Figs. 6A and 6B, the rotary body 25 is supported such that it can move independently from the fixed base 30 and the fixed board 40 only in the X1-X2 direction (a predetermined direction on the surface of the board in plan view) orthogonal to the shaft. Meanwhile, the photo interrupter 33 is mounted to the surface of the fixed board 40 fixed to the fixed base 30, and thus fixed to the fixed base 30. The arrangement of the photo interrupter 33 with respect to the code unit 39 is restricted such that, in the entire movement range of the rotary body 25, the photo interrupter 33 does not contact the light shielding portion 37 of the code unit 39 all the time and the code unit 39 is positioned between the light emitting portion 41 and the light receiving portion 42 all the time in plan view.

As described above, in this embodiment, unlike the related art, even when the photo interrupter 33 is fixed without moving together with the rotary body 25, it is possible to move the rotary body 25 in a predetermined direction, independently from the fixed base 30 and the fixed board 40, by appropriately restricting the arrangement of the photo interrupter 33 with respect to the code unit 39. Therefore, unlike the related art, a long flexible wiring board, which does not hinder the movement of the photo interrupter 33 that moves together with the rotary body 25, a movable board that moves together with the photo interrupter 33, and a support mechanism therefor are not needed. Therefore, it is possible to reduce the number of parts.

Further, unlike the related art, a space for accommodating the long flexible wiring board is not needed, and thus it is possible to reduce the number of parts. As a result, it is possible to reduce the size of the rotary device 24.

In this embodiment, it is preferable to arrange the photo interrupter 33 such that the direction of the straight line E linking the center of the light emitting portion 41 in the width direction and the center of the light receiving portion 42 in the width direction is different from the direction in which the rotary body 25 is moved. When the direction of the straight line E is aligned with the movement direction of the rotary body 25, it is difficult to move the rotary body 25 beyond the gap between the light emitting portion 41 and the light receiving portion 42. Meanwhile, when the direction of the straight line E linking the center of the light emitting portion 41 in the width direction and the center of the light receiving portion 42 in the width direction is different from the direction in which the rotary body 25 is moved, it is possible to extend the movement range of the rotary body 25 or flexibly set the movement range by changing, for example, the shape or dimensions of the code unit 39. As in the embodiment shown in Figs. 6A and 6B, when the direction of the straight line E is orthogonal to the movement direction of the rotary body 25 and the rotary body 25 is positioned at the center (center position) in the movement direction (X1-X2 direction), it is preferable that the photo interrupter 33 be arranged such that the straight line E passes through the rotation center O1. This restriction makes it possible to effectively extend the movement range of the rotary body 25 that maintains a non-contact state between the photo interrupter 33 and the light shielding portion 37 of the code unit 39. In addition, the displacement of the rotary body 25 from the center position shown in Fig. 6A to the left position shown in Fig. 6B in the X1 direction may be set equal to the displacement of the rotary body 25 from the center position shown in Fig. 6A to the right position in the X2 direction.

It is possible to move the rotary body 25 a distance T1 from the center position shown in Fig. 6A to the left position shown in Fig. 6B in the X1 direction. In addition, it is also possible to move the rotary body 25 the distance T1 from the center position shown in Fig. 6A to the right position (in the X2 direction). Therefore, it is possible to make the movement distance from the center position to the left position equal to the movement distance from the center position to the right position, and it is also possible to set the entire movement range of the rotary body 25 to 2 x T1.

In the embodiment shown in Fig. 7, a pair of photo interrupters 33 and 50 are fixed to the fixed board 40.

The photo interrupter 33 is for counting pulses, and the photo interrupter 50 is for detecting the direction. In this way, it is possible to appropriately detect the rotation angle and rotation direction of the rotary body 25.

As shown in Fig. 7, when the rotary body 25 is positioned at the center (center position) of the movement range, the pair of photo interrupters 33 and 50 are arranged substantially opposite to each other with the rotation center O1 interposed therebetween. The pair of photo interrupters 33 and 50 are not arranged directly opposite to each other with the rotation center O1 interposed therebetween, but the photo interrupter 50 slightly deviates from a line linking the photo interrupter 33 and the rotation center O1. This is to appropriately detect both the rotation angle and the rotation direction. The term 'substantially opposite' indicates that the photo interrupter 50 is opposite to the photo interrupter 33 so as to satisfy the following relationship.

In the embodiment shown in Fig. 7, for example, the positions of the photo interrupters 33 and 50 are restricted such that, when the light shielding portion 37 of the code unit 39 is arranged in the light detection space between the light emitting portion 41 and the light receiving portion 42 of the photo interrupter 33, a portion (almost half in Fig. 7) of the light shielding portion 37 is disposed in the light detection space between the light emitting portion 41 and the light receiving portion 42 of the photo interrupter 50. In this way, signals obtained from the photo interrupter 50 depend on whether the rotary body 25 is rotated in a clockwise direction or in a counterclockwise direction from the state shown in Fig. 7. Therefore, it is possible to detect the rotation direction on the basis of the signals. When the pair of photo interrupters 33 and 50 are arranged directly opposite to each other with the rotation center O1 interposed therebetween and the positional relationship between the photo interrupters 33 and 50 and the code member 39 satisfies the above-mentioned relationship, it is possible to arrange the pair of photo interrupters 33 and 50 so as to be opposite to each other with the rotation center O1 interposed therebetween. As shown in Fig. 7, when the pair of photo interrupters 33 and 50 are arranged substantially opposite to each other with the rotation center O1 interposed therebetween, it is possible to effectively extend the movement range of the rotary body 25 that maintains a non-contact state between the photo interrupters 33 and 50 and the light shielding portion 37 of the code unit 39, as compared to the structure in which the photo interrupters 33 and 50 are arranged directly opposite to each other.

In the embodiment shown in Fig. 8, when the rotary body 25 is positioned at the center (center position) of the movement range, the photo interrupter 33 is arranged such that the center C between the light emitting portion 41 and the light receiving portion 42 is closer to the rotation center O1 than the center D of the light shielding portion 37 of the code unit 39 in the width direction.

The structure shown in Fig. 8 makes it possible to effectively extend the movement range of the rotary body 25 that maintains a non-contact state between the photo interrupter 33 and the light shielding portion 37 of the code unit 39.

In the structure in which the center C between the light emitting portion 41 and the light receiving portion 42 is closer to the rotation center O1 than the center D of the light shielding portion 37 of the code unit 39 in the width direction, it is a precondition that the photo interrupter 33 is arranged such that the direction (Y direction) of the straight line E linking the center of the light emitting portion 41 in the width direction and the center of the light receiving portion 42 in the width direction is different from the direction (X1-X2 direction) in which the rotary body 25 is moved. In particular, it is possible to more effectively extend the movement range of the rotary body 25 by arranging the photo interrupter 33 such that the direction (Y direction) of the straight line E is orthogonal to the direction (X1-X2 direction) in which the rotary body 25 is moved, and when the rotary body 25 is positioned at the center of the movement direction, the straight line E passes through the rotation center O1, as shown in Fig. 8.

In the rotary device 24 that can be rotated to three positions, that is, the center position, the left position, and the right position shown in Figs. 6A and 6B to input signals, the rotary body 25 may be urged to the center position by, for example, a torsion spring.

Alternatively, as shown in Fig. 9, the rotary device may be rotated to two positions to input signals. In this case, the rotary body 25 is supported so as to be movable between two positions, that is a first position (left position) having a rotation center 02 and a second position (right position) having a rotation center 03. In this case, it is preferable that the photo interrupter 33 be arranged at the intersection between the first position of the code unit 39 and the second position of the code unit 39. In this way, it is possible to rotate the rotary device to input signals while appropriately maintaining a non-contact state between the photo interrupter 33 and the light shielding portion 37 of the code unit 39 at both the first position and the second position. In addition, it is possible to effectively extend the movement range of the rotary body 25 that maintains the non-contact state between the photo interrupter 33 and the light shielding portion 37 of the code unit 39.

In the two-position structure in which the photo interrupter 33 is arranged at the intersection between the first position of the code unit 39 and the second position of the code unit 39, it is possible to more effectively extend the movement range of the rotary body 25 by arranging the photo interrupter 33 such that the direction of the straight line E linking the center of the light emitting portion 41 in the width direction and the center of the light receiving portion 42 in the width direction is orthogonal to the direction (X1-X2 direction) in which the rotary body 25 is moved, and when the rotary body 25 is positioned at the center of the movement direction, the straight line E passes through the rotation center O1, as shown in Fig. 9.

In the above-described embodiments, the rotary body 25 is moved in a straight line, but the invention is not limited thereto. For example, the rotary body may be moved in an arc. Further, in the above-described embodiments, the direction of the rotation axis of the rotary body 25 is fixed to the Z direction, but the invention is not limited thereto. For example, the rotation axis may be slightly inclined from the Z direction. Even in the movement range of the rotary body 25 having a rotation axis slightly inclined, according to this embodiment, it is possible to control the photo interrupter 33 and the light shielding portion 37 of the code member 32 such that they do not contact with each other all the time. Furthermore, it is possible to move the rotary body 25 in an arc or a straight line with the rotation axis being inclined.

## Claims

1. A rotary device comprising:
a rotary body (25) rotatably supported above a fixed base (30);
a code member (32) provided below the rotary body (25) so as to be rotatably supported together with the rotary body (25) and including a code unit (39) having light shielding portions (37) and light transmitting portions (38) alternately arranged in a rotation direction; and
a photo interrupter (33) including a light emitting portion (41) and a light receiving portion (42) that are opposite to each other with a gap therebetween such that, when the code member (32) is rotated, the light shielding portion (37) is positioned in a light detection space between the light emitting portion (41) and the light receiving portion (42),
**characterized in that** the rotary body (25) is supported in a direction substantially orthogonal to a rotation axis such that it can move independently from the fixed base (30),
the photo interrupter (33) is fixed to the fixed base (30), and
the arrangement of the photo interrupter (33) with respect to the code unit (39) is configured such that, in the entire movement range of the rotary body (25), the photo interrupter (33) does not contact the light shielding portion (37) of the code unit (39) all the time and the code unit (39) is positioned between the light receiving portion (42) and the light emitting portion (41) all the time.

2. The rotary device according to claim 1,
**characterized in that** the photo interrupter (33) is arranged such that the direction of a straight line (E) linking the center of the light emitting portion (41) in the width direction and the center of the light receiving portion (42) in the width direction is different from the direction (X1-X2) in which the rotary body (25) is moved.

3. The rotary device according to claim 2,
**characterized in that** the photo interrupter (33) is arranged such that the direction of a straight line (E) linking the center of the light emitting portion (41) in the width direction and the center of the light receiving portion (42) in the width direction is orthogonal to the direction (X1-X2) in which the rotary body (25) is moved, and when the rotary body (25) is positioned at the middle of the movement range, the straight line (E) passes through a rotation center (O1).

4. The rotary device according to claim 2 or 3,
**characterized in that**, when the rotary body (25)is positioned at the middle of the movement range, the photo interrupter (33) is arranged such that the center between the light emitting portion (41) and the light receiving portion (42) is closer to the rotation center (O1) than the center of the width of the code unit (39).

5. The rotary device according to any one of claims 2 to 4,
**characterized in that** the rotary body (25) is supported such that it can be moved between a first position and a second position for rotation, and
the photo interrupter (33) is arranged at the intersection between the first position of the code unit (39) and the second position of the code unit (39).

6. The rotary device according to any one of claims 1 to 5,
**characterized in that** a pair of the photo interrupters (33, 50) are provided, and
the pair of photo interrupters (33, 50) are substantially opposite to each other with a rotation center (01) interposed therebetween when the rotary body (25) is positioned at the center of the movement direction.
